(19) Europäisches Patentamt
European Patent Office
Office européen des brevets

(11) **EP 4 203 352 A1**

(12) **EUROPEAN PATENT APPLICATION**
published in accordance with Art. 153(4) EPC

(43) Date of publication:
**28.06.2023 Bulletin 2023/26**

(21) Application number: **20952051.9**

(22) Date of filing: **07.09.2020**

(51) International Patent Classification (IPC):
**H04L 1/00** (2006.01)　　**H03M 13/09** (2006.01)

(52) Cooperative Patent Classification (CPC):
**H04L 1/0041; H03M 13/09; H04L 1/00;
H04L 1/0084**

(86) International application number:
**PCT/CN2020/113853**

(87) International publication number:
**WO 2022/047809 (10.03.2022 Gazette 2022/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **JIN, Lili
Shenzhen, Guangdong 518129 (CN)**

• **CHENG, Xingqing
Shenzhen, Guangdong 518129 (CN)**
• **WANG, Jian
Shenzhen, Guangdong 518129 (CN)**
• **LIU, Hang
Shenzhen, Guangdong 518129 (CN)**
• **GAO, Lei
Shenzhen, Guangdong 518129 (CN)**

(74) Representative: **Thun, Clemens
Mitscherlich PartmbB
Patent- und Rechtsanwälte
Sonnenstraße 33
80331 München (DE)**

(54) **COMMUNICATION METHOD AND APPARATUS**

(57)　　Embodiments of this application provide a communication method and an apparatus, applied to the communication field, and in particular, to the short-range communication field, for example, an in-vehicle wireless communication system, a smart home system, or a smart manufacturing system. The method includes: A first node performs channel coding on at least one code block; and the first node sends, to a second node, the at least one code block on which channel coding has been performed, where the at least one code block is a code block of a first service. This solution may be further used to improve a capability of autonomous driving or an advanced driver-assistance system ADAS, and may be applied to internet of vehicles, for example, vehicle to everything V2X, long term evolution-vehicle LTE-V, and vehicle-to-vehicle V2V

FIG. 4

**Description**

**TECHNICAL FIELD**

This application relates to the field of communication technologies, and in particular, to a communication method and an apparatus.

**BACKGROUND**

As global communication technologies gradually develop, a development speed and application of wireless communication technologies have surpassed those of fixed communication technologies, and the wireless communication technologies develop in full swing. Intelligent terminals such as intelligent transportation devices, smart home devices, and robots gradually enter people's daily life.

The intelligent transportation device is used as an example. Development and application of an internet of vehicles technology attract more attention. In comparison with wired communication, in-vehicle wireless communication can further reduce a quantity, length, and weight of cable harnesses in a vehicle, and can reduce installation and maintenance costs of software and hardware in the vehicle. However, as functions of the vehicle become increasingly complex, and a quantity and types of in-vehicle communication nodes increase, a higher requirement is imposed on a capability of in-vehicle wireless communication. For two nodes in in-vehicle wireless communication, how to perform channel coding on a transmitted service is a problem to be resolved in embodiments of this application.

**SUMMARY**

This application provides a communication method and an apparatus, to determine a channel coding scheme for a service transmitted between two nodes.

According to a first aspect, a communication method is provided. The method is performed by a first node, or a component (a chip, a circuit, or the like) disposed in a first node. The method includes: The first node performs channel coding on at least one code block; and the first node sends at least one encoded code block to a second node, where the at least one code block is a code block of a first service. Optionally, the first service may also be referred to as a first-type data service, a noise reduction data service, an active noise reduction service, or the like.

It should be noted that the solution of this application focuses on describing a channel coding scheme of a code block. Therefore, in the foregoing method, only "sending at least one CB on which channel coding has been performed" is described. However, a person skilled in the art may learn that the first node does not send the at least one CB to the second node after performing only channel coding on the at least one CB. An actual communication process may further include but is not limited to: The first node performs at least one type of processing of rate matching, code block concatenation, data and control multiplexing, or channel interleaving on the at least one CB on which channel coding has been performed; and then sends, to the second node, at least one CB obtained after the at least one type of processing (or a bit stream corresponding to the at least one CB).

In a possible design, the method further includes: The first node obtains at least one of a size of a code block or a quantity of code blocks corresponding to the first service; and the first node obtains the at least one code block by using at least one transport block of the first service based on the at least one of the size of the code block or the quantity of code blocks.

According to the foregoing method, the at least one of the size of the code block or the quantity of code blocks may be preconfigured on the first node and the second node; the first node or the second node may exchange the at least one of the size of the code block or the quantity of code blocks by using higher layer signaling; or a master node of the first node or the second node may send the at least one of the size of the code block or the quantity of code blocks to a slave node of the first node or the second node. This implementation is flexible.

In a possible design, the size of the code block is a sum of a size of an information bit of the code block and a size of a cyclic redundancy check CRC, or the size of the code block is a size of an information bit of the code block. Optionally, the size of the CRC may be specified in a protocol, or may be preconfigured. This is not limited.

It can be learned from the foregoing that the size of the CB may be the size of the information bit of the CB, or the sum of the size of the information bit and the size of the cyclic redundancy check CRC. In an implementation, if the size that is of the CB and that is obtained by the second node is the size of the information bit of the CB, the second node needs to obtain the at least one CB by using a first transport block TB based on the size of the CB and the size of the CRC. In another implementation, if the size that is of the CB and that is obtained by the second node is the sum of the size of the information bit and the size of the cyclic redundancy check CRC, the second node obtains the at least one CB by using a first TB based on the obtained size of the CB.

In a possible design, no CRC is attached to the at least one transport block of the first service.

According to the foregoing method, complexity of channel coding is reduced. Especially for a service that has a relatively high latency requirement, for example, the first service, a length of transmitted information may be reduced, so that a low latency is further ensured while complexity of channel coding is reduced.

In a possible design, the performing channel coding on at least one code block includes: performing channel coding on each of the at least one code block based on a mother code length of the code block, where the mother code length of the code block is determined based on at least one of a maximum mother code length, a minimum mother code length, or a minimum mother code rate; or performing channel coding on the at least one code block based on a mother code length of a code block, where the mother code length of the code block is determined based on at least one of a maximum mother code length, a minimum mother code length, or a minimum mother code rate.

In a possible design, the maximum mother code length is 128 or 256.

In a possible design, the minimum mother code length is 32.

It can be learned from the foregoing method that the maximum mother code length of the first-type data service is limited to 128, so that device complexity is reduced while a service requirement is met; and the minimum mother code length of the first-type data service is limited to 32, so that a service requirement that a minimum length of a CB is 24 bits can be met.

In a possible design, the minimum mother code rate is 1/8.

In a possible design, the method further includes: The first node sends indication information to the second node, where the indication information may be included in node capability information, auxiliary information, or the like. For example, the auxiliary information may include at least one of service feature information, attribute information, or the like. Optionally, the indication information may be a part or all of the attribute information, or the indication information may be a part or all of the service feature information. Specifically, the indication information is used for indicating the at least one of the size of the code block or the quantity of code blocks corresponding to the first service. Alternatively, the first node receives indication information from the second node, where the indication information is used for indicating the at least one of the size of the code block or the quantity of code blocks corresponding to the first service. Further optionally, the indication information may be carried in higher layer signaling, for example, radio resource control signaling.

According to the foregoing method, the first node or the second node receives the indication information to obtain the at least one of the size of the CB or the quantity of CBs, so that the CB can be configured more flexibly.

According to a second aspect, a communication method is provided. The method is performed by a second node, or a component (a chip, a circuit, or the like) disposed in a second node. The method includes: The second node receives a first service from a first node, where the first service includes at least one code block; and the second node performs channel decoding on the at least one code block. Optionally, the first service may also be referred to as a first-type data service, a noise reduction data service, an active noise reduction service, or the like.

It should be noted that this embodiment of this application focuses a process of performing channel decoding on a code block. A person skilled in the art may learn that the second node may further perform at least one of channel de-interleaving, data and control demultiplexing, code block de-concatenation, or rate de-matching on the at least one code block or at least one transport block.

In a possible design, the method further includes: The second node obtains at least one of a size of a code block or a quantity of code blocks corresponding to the first service; and the second node obtains at least one transport block of the first service based on the at least one of the size of the code block or the quantity of code blocks.

In a possible design, the size of the code block is a sum of a size of an information bit of the code block and a size of a cyclic redundancy check CRC, or the size of the code block is a size of an information bit of the code block.

In a possible design, no CRC is attached to the at least one transport block of the first service.

According to the foregoing method, complexity of channel coding is reduced. Especially for a service that has a relatively high latency requirement, for example, the first service, a length of transmitted information may be reduced, so that a low latency is further ensured while complexity of channel coding is reduced.

In a possible design, the performing channel decoding on the at least one code block includes: performing channel decoding on each of the at least one code block based on a mother code length of the code block, where the mother code length of the code block is determined based on at least one of a maximum mother code length, a minimum mother code length, or a minimum mother code rate; or performing channel decoding on the at least one code block based on a mother code length of a code block, where the mother code length of the code block is determined based on at least one of a maximum mother code length, a minimum mother code length, or a minimum mother code rate.

In a possible design, the maximum mother code length is 128 or 256.

In a possible design, the minimum mother code length is 32.

It can be learned from the foregoing method that the maximum mother code length of the first-type data service is limited to 128, so that device complexity is reduced while a service requirement is met; and the minimum mother code length of the first-type data service is limited to 32, so that a service requirement that a minimum length of a CB is 24 bits can be met.

In a possible design, the minimum mother code rate is 1/8.

In a possible design, the method further includes: The second node receives indication information from the first node, where the indication information is used for indicating the at least one of the size of the code block or the quantity of code blocks corresponding to the first service; or the second node sends indication information to the first node, where the indication information is used for indicating the at least one of the size of the code block or the quantity of code blocks corresponding to the first service. Optionally, the indication information may be included in node capability information, auxiliary information, or the like. For example, the auxiliary information may include at least one of service feature information, attribute information, or the like. The indication information may be a part or all of the attribute information, or the indication information may be a part or all of the service feature information. Further optionally, the indication information may be carried in higher layer signaling, for example, radio resource control signaling.

According to a third aspect, an apparatus is provided. For beneficial effects, refer to the description of the first aspect. The apparatus has functions of implementing the behaviors in the method embodiment in the first aspect. The functions may be implemented by executing corresponding hardware or software. The hardware or the software may include one or more units corresponding to the foregoing functions. In a possible design, the apparatus includes: a processing unit, configured to perform channel coding on at least one code block; and a communication unit, configured to send, to a second node, the at least one code block on which channel coding has been performed, where the at least one code block is a code block of a first service. These units may perform the corresponding functions in the method example in the first aspect. For details, refer to the detailed description in the method example. Details are not described herein again.

According to a fourth aspect, an apparatus is provided. For beneficial effects, refer to the description of the second aspect. The apparatus has functions of implementing the behaviors in the method embodiment in the second aspect. The functions may be implemented by executing corresponding hardware or software. The hardware or the software may include one or more units corresponding to the foregoing functions. In a possible design, the apparatus includes: a communication unit, configured to receive a first service from a first node, where the first service includes at least one code block; and a processing unit, configured to perform channel decoding on the at least one code block. These units may perform the corresponding functions in the method example in the second aspect. For details, refer to the detailed description in the method example. Details are not described herein again.

According to a fifth aspect, an apparatus is provided. The apparatus includes a communication interface and at least one processor, and optionally, further includes a memory. The memory is configured to store a computer program or instructions. When the at least one processor executes the computer program or the instructions, the apparatus is enabled to perform the method performed by the first node in the method embodiment in the first aspect. Optionally, the apparatus may be a chip system or an integrated circuit.

According to a sixth aspect, an apparatus is provided. The apparatus includes a communication interface and at least one processor, and optionally, further includes a memory. The memory is configured to store a computer program or instructions. When the at least one processor executes the computer program or the instructions, the apparatus is enabled to perform the method performed by the second node in the method embodiment in the second aspect. Optionally, the apparatus may be a chip system or an integrated circuit.

According to a seventh aspect, a computer program product is provided. The computer program product includes computer program code, and when the computer program code is run, the method performed by the first node in the first aspect is performed.

According to an eighth aspect, a computer program product is provided. The computer program product includes computer program code, and when the computer program code is run, the method performed by the second node in the second aspect is performed.

According to a ninth aspect, a chip system is provided. The chip system includes at least one processor, configured to implement a function of the first node in the method in the first aspect. In a possible design, the chip system further includes a memory, configured to store program instructions and/or data. The chip system may include a chip, or may include a chip and another discrete device.

According to a tenth aspect, a chip system is provided. The chip system includes at least one processor, configured to implement a function of the second node in the method in the second aspect. In a possible design, the chip system further includes a memory, configured to store program instructions and/or data. The chip system may include a chip, or may include a chip and another discrete device.

According to an eleventh aspect, a computer-readable storage medium is provided. The computer-readable storage medium stores a computer program, and when the computer program is run, the method performed by the first node in the first aspect is implemented.

According to a twelfth aspect, a computer-readable storage medium is provided. The computer-readable storage medium stores a computer program, and when the computer program is run, the method performed by the second node in the second aspect is implemented.

According to a thirteenth aspect, a system is provided. The system includes at least one of the apparatus in the third aspect or the fifth aspect and the apparatus in the fourth aspect or the sixth aspect.

**BRIEF DESCRIPTION OF DRAWINGS**

FIG. 1 is a schematic diagram of an application scenario according to an embodiment of this application;
FIG. 2 is another schematic diagram of an application scenario according to an embodiment of this application;
FIG. 3 is a schematic diagram of a channel coding scheme according to an embodiment of this application;
FIG. 4 is a flowchart of a communication method according to an embodiment of this application;
FIG. 5 is a schematic diagram of a structure of an apparatus according to an embodiment of this application; and
FIG. 6 is a schematic diagram of another structure of an apparatus according to an embodiment of this application.

**DESCRIPTION OF EMBODIMENTS**

To make objectives, technical solutions, and advantages of this application clearer, the following further describes this application in detail with reference to the accompanying drawings.

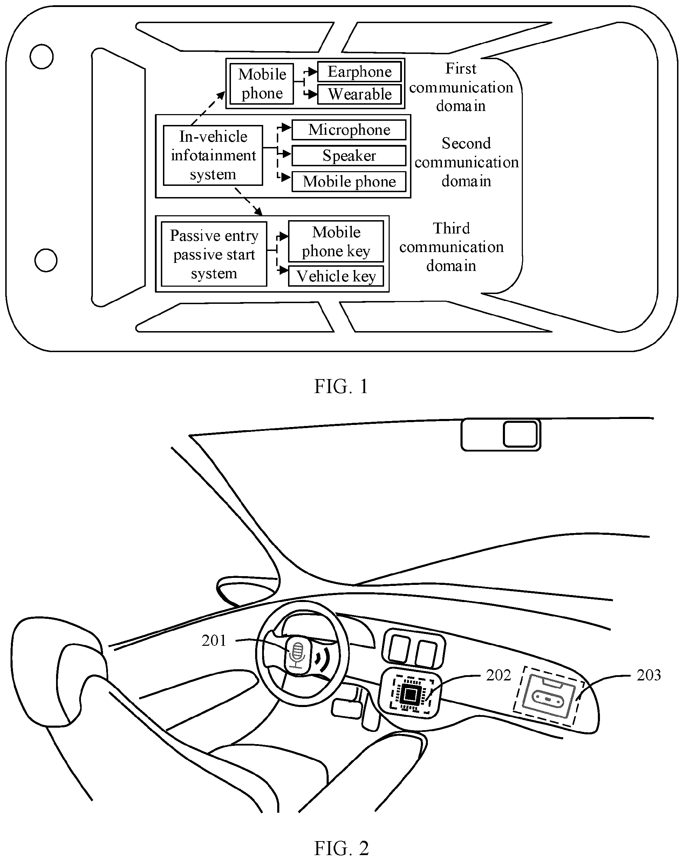

In a wireless communication scenario in which an intelligent terminal is located, there may be a plurality of communication domains in a specific communication area or range. FIG. 1 is a schematic diagram of a topological relationship of in-vehicle communication links. The communication domain is a system including: a group of communication nodes that have a communication relationship, and a communication connection relationship (that is, a communication link) between the communication nodes. One communication domain includes one master communication node, which may be referred to as a master node for short, and at least one slave communication node, which may be referred to as a slave node for short. The master node manages a time-frequency resource in the communication domain, and has a function of scheduling a resource for a communication link between slave nodes. A node that does not belong to the communication domain may be referred to as an external node for short, includes a device that has never joined the communication domain and a device that has joined the communication domain and then exits the communication domain, and may be converted into a slave node of the communication domain through a process of joining the communication domain. In the process of joining the communication domain, the external node first needs to synchronize with the communication domain, and obtain system information such as a resource configuration and a supported feature of the communication domain. In some embodiments, as shown in FIG. 1, the intra-vehicle communication link includes at least one of the following communication domains: a first communication domain including a mobile phone, earphones, a wearable device, and the like, a second communication domain including an in-vehicle infotainment system, a microphone, a sound box, a mobile phone, and the like, and a third communication domain including a passive entry passive start system, a mobile phone key, a vehicle key, and the like.

Two nodes in a same communication domain or different communication domains may communicate with each other. An example in which two communication nodes are a first node and a second node is used for description. In a possible scenario, as shown in FIG. 2, a microphone 201 supporting a wireless communication technology in a vehicle may be considered as the first node; and a cockpit domain controller (cockpit domain controller, CDC) 202 in the vehicle is a control center in a smart cockpit device, and may be considered as the second node. A wireless connection may be established between the CDC 202 and the microphone 201. The CDC 202 may obtain, by using the wireless communication technology, audio recorded by the microphone 201, record a driving process and/or external noise, and the like. For another example, a speaker (or referred to as a loudspeaker) 203 supporting the wireless communication technology in the vehicle may be considered as the first node, and a wireless connection may be established between the CDC 202 and the speaker 203. In this way, the speaker 203 can receive and play audio sent by the CDC 202. How to perform channel coding on a service transmitted between the first node and the second node is a technical problem to be resolved in embodiments of this application.

Embodiments of this application provide a communication method and an apparatus. The method includes: A first node performs channel coding on at least one code block; and the first node sends, to a second node, the at least one code block on which channel coding has been performed, where the at least one code block may be a code block of a first service.

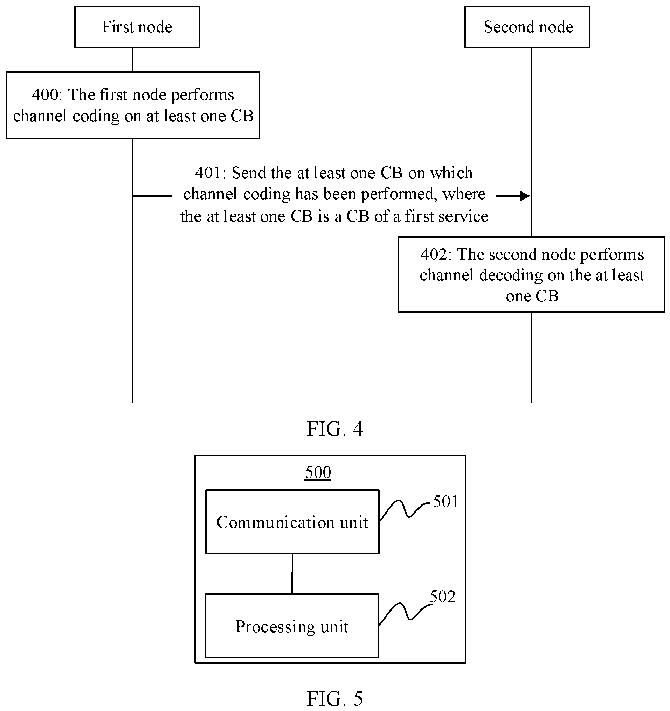

In in-vehicle wireless communication, two types of data services may be included: a first-type data service and a second-type data service. The first-type data service is also referred to as a noise reduction service, and is characterized by that a relatively small data block is transmitted and a latency requirement is high. Channel coding for the first-type data service may use a Reed-Solomon code (Reed-Solomon code, RS code), a Polar code, or the like. The second-type data service is mainly a streaming rear-view mirror/360° surround view service, interconnection and projection of a mobile phone and an in-vehicle infotainment system, and the like, and is mainly characterized by that a rate is relatively high and the service is insensitive to a latency. Channel coding for the second-type data service may use a Polar code or the like. The method provided in embodiments of this application may be mainly applied to channel coding for the foregoing first-type data service. Whether channel coding is performed on the second-type data service by using the method provided in embodiments of this application is not limited. In some embodiments, a channel coding scheme for the first-type data service is different from a channel coding scheme for the second-type data service. For example, a maximum mother code length corresponding to the first-type data service is 128 or 256, and a maximum mother code length corresponding to the second-type data service is 4096. For the channel coding scheme for the first-type data service, refer to the following description in FIG. 4.

In a possible implementation, the channel coding scheme for the second-type data service is as follows:

- A size of a TB is first determined based on a resource allocated by a physical layer, a coding rate, a modulation scheme, and the like.
- A CRC is attached to the TB. For example, a length of the CRC is 24 bits.
- A value of a maximum allowed length $K_{cb}$ of a code block is determined, for example, $K_{cb}$ = ceil((4096*R)/)*8, where R represents a code rate.
- A quantity C of segments into which the TB is divided is determined based on a length of the TB and the value of $K_{cb}$.
- A length of each code block is determined based on the quantity C of segments and the length of the TB.
- The CRC is attached to each code block.
- A mother code length of a Polar code is determined based on the length of each code block, where a maximum allowed mother code length is 4096.
- Channel coding is performed on each code block.

It should be noted that a system architecture and a service scenario described in this application are intended to describe the technical solutions in this application more clearly, but do not constitute a limitation on the technical solutions provided in this application. A person skilled in the art may learn that, with evolution of the system architecture and emergence of a new service scenario, the technical solutions provided in this application are also applicable to similar technical problems. For example, embodiments of this application may also be applied to air interface communication. The first node may be a terminal device, and the second node may be a network device. Alternatively, the first node may be a network device, and the second node may be a terminal device.

Network elements in embodiments of this application include the first node, the second node, and the like. The node may be an electronic device having a data receiving and sending processing capability, and may include a terminal device or a network device, or may be a chip included in a terminal device or a network device. For example, the node may be a vehicle cockpit (Cockpit Domain) device, or a module in a vehicle cockpit device, for example, at least one or more of modules such as a cockpit domain controller (cockpit domain controller, CDC), a camera, a screen, a microphone, a speaker, an electronic key, and a passive entry passive start controller. In a specific embodiment, the node may alternatively be a data transfer device, for example, a base station, a router, a repeater, a bridge, or a switch; or may be a terminal device, for example, any type of user equipment (user equipment, UE), a mobile phone (mobile phone), a tablet computer (pad), a desktop computer, earphones, or a speaker; or may include a machine intelligence device such as a self-driving (self-driving) device, a transportation safety (transportation safety) device, a virtual reality (virtual reality, VR) terminal device, an augmented reality (augmented reality, AR) terminal device, a machine type communication (machine type communication, MTC) device, an industrial control (industrial control) device, a telemedicine (remote medical) device, a smart grid (smart grid) device, or a smart city (smart city) device, or may include a wearable device (for example, a smart watch, a smart band, or a pedometer), or the like. In some technical scenarios, a name of a device having a similar data receiving and sending capability may not be referred to as a node. However, for ease of description, electronic devices having a data receiving and sending capability are collectively referred to as nodes in embodiments of this application.

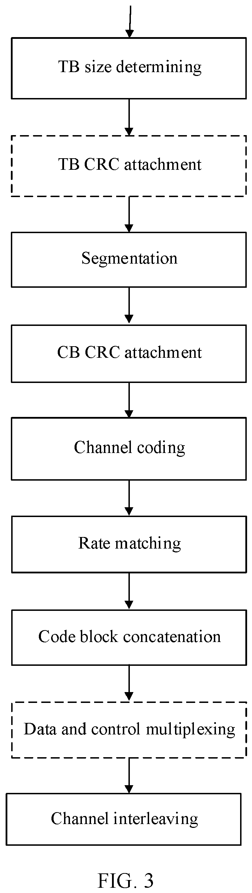

For ease of understanding, a process related to channel coding is first described. In wireless communication, generally, one piece of downlink control information, control signaling carried on a C link, or other possible control signaling may be used for scheduling one transport block (transport block, TB) or schedule a TB carried on one data channel. The data channel may be a physical downlink data channel or a physical uplink data channel. Generally, due to a limitation of a channel coding length, one TB is divided into a plurality of code blocks (code blocks, CBs). As shown in FIG. 3, a main coding scheme includes at least one of the following:

- A cyclic redundancy check (cyclic redundancy check, CRC) is attached to the TB. Optionally, in this embodiment of this application, as shown in FIG. 3, the CRC may be first attached to the TB, and then the TB is segmented. Alternatively, the TB may be directly segmented, and no CRC is attached to the TB, so that complexity of channel coding is reduced. For the first-type data service, it is not necessary to attach the CRC. If the CRC is no longer attached to the TB corresponding to the first-type data service, the channel coding scheme can match a feature of first-type service data. In this way, a data length of the sent first-type service data is reduced.
- The TB is segmented and the CRC is attached to a CB. For example, in a Turbo code, B is used for representing a length of the TB to which the CRC is attached, and Z = 1644 represents a maximum allowed code block length.

When B > 1644, the TB needs to be segmented, and a quantity of code blocks obtained after the TB is segmented is $C = \lceil B/(Z-L) \rceil$, where L represents a length of the CRC. For a Polar code, a segmentation method is similar to that for the Turbo code. B is used for representing a length of the TB to which the CRC is attached, $K_{cb}$ = ceil((4096*R)/)*8, R represents a code rate, and ceil represents rounding down. When B > $K_{cb}$, a quantity of segments is $C = \lceil B/(K_{cb}-L) \rceil$, where L represents the length of the CRC.

- Channel coding is performed. Optionally, a channel coding scheme may be a Polar code, a Turbo code, an RS code, or even a low-density parity-check (low-density parity-check, LDPC) code. This is not limited.
- Rate matching is performed.
- Code block concatenation is performed.
- Data and control multiplexing is performed, where data and control multiplexing is an optional operation. In a design, channel interleaving is performed after code block concatenation. In another design, after code block concatenation, data and control multiplexing is first performed, and then channel interleaving and the like are performed.
- Channel interleaving is performed.

Embodiments of this application focus a TB segmentation process and a channel coding process, and other processes are not described in detail.

In a design, it may be considered that one protocol data unit (protocol data unit, PDU) at a media access control (media access control, MAC) layer corresponds to one TB.

For ease of understanding, terms or nouns that may be used in embodiments of this application are first described. The terms or nouns are also used as a part of invention content of embodiments of this application.

1. Length of a CB: In one understanding, the length of the CB is a length of an information bit of the CB. In another understanding, the length of the CB is a sum of a length of an information bit of the CB and a length of a CRC. For example, a length of one CB is 16 bits, and a length of an attached CRC is 8 bits. In this case, in embodiments of this application, the length of the CB may be 16 bits, or may be 24 bits. In the following description, the "length" and the "size" are not distinguished, and may be replaced with each other. For example, the length of the CB may be replaced with the size of the CB, or the size of the CB may be replaced with the length of the CB.

2. Mother code length: The mother code length is a length obtained after channel coding is performed on a CB. The length may be in a unit of bit. The channel coding scheme may be a Polar code, an RS code, a Turbo code, even an LDPC code, or the like. This is not limited.

3. Mother code rate: The mother code rate may also be referred to as a code rate, and is a ratio of a length of a CB after channel coding to a length of the CB before channel coding. For example, if the length of the CB before channel coding is 40 bits, and the length of the CB after channel coding is 120 bits, the mother code rate may be 40/120 = 1/3.

4. First service: The first service may also be referred to as a first-type data service, a noise reduction service, a noise reduction data service, an active noise reduction service, or the like. A length of an information bit of a CB corresponding to the first service is relatively short, and a latency requirement is relatively high. For example, the first service meets one or more of the following conditions: A sampling frequency is approximately 48 KHz ("approximately" herein reflects a possible error); only semi-persistent scheduling transmission is supported, and scheduling information is sent by using higher layer signaling; an information bit length of each code block is K, or a length of sampled data at each sampling point is 16, 24, or 32 bits; a coding scheme is an RS code or a Polar code; or a modulation scheme is at least one of QPSK, 16QAM, 64QAM, 256QAM, 1024QAM, or the like. In a specific example, the first service meets all the foregoing conditions, and for each radio frame, a size of one transport block is K*N bits, where every K bits constitute a group to constitute N code blocks. Channel coding is performed on the code blocks for sending.

5. Size of a CB and/or a quantity of CBs: In one understanding, the size of the CB is a size of each CB, and the quantity of CBs is a quantity of CBs included in one TB. For example, if one TB is 2400 bits, and the size of each CB may be 30 bits, the TB may include 80 CBs. Certainly, whether sizes of CBs included in one TB are the same is not limited. For example, sizes of CBs included in one TB may be the same, as shown in the foregoing example. Alternatively, sizes of CBs included in one TB may be different. For example, one TB includes three CBs, and sizes of the three CBs are N1, N2, and N3, where at least two of N1, N2, and N3 have different values. In another understanding, the size of the CB may be represented by using a related term such as a quantity of sampling bits (or precision), where the quantity of sampling bits (or precision) may be considered as a size, a length, or the like of an external signal sampled by a sampling device in each sampling cycle. The quantity of CBs may be represented by using a related attribute such as a quantity of sampling devices. Microphones, speakers, and the like in an in-vehicle environment are mostly arranged in an array form. Microphones are used as an example. A microphone array is usually a linear array, a disk planar array, a spatial array, or the like. Sampling precision of different microphone arrays may be the same or different. For example, a quantity of sampling bits of a microphone array 1, a microphone array 2, and a microphone array 3 may be respectively 16 bits, 24 bits, and 32 bits. A quantity of sampling bits of each microphone in each microphone array in one sampling cycle may be considered as a size of one CB. For example, the microphone arrays 1, 2, and 3 collect external audio signals based on their respective sampling precision, and send the external audio signals to a processing module. The processing module may pack 16-bit audio data, 32-bit audio data, and 64-bit audio data that are respectively sampled by the three microphone arrays in one sampling cycle into one TB.

It should be noted that the size of the CB and/or the quantity of CBs each may have different values based on different devices, different applications, different configurations, or the like corresponding to the first node and the second node.

In addition, in descriptions of this application, unless otherwise specified, "/" indicates an "or" relationship between associated objects. For example, A/B may indicate A or B. In this application, "and/or" describes only an association relationship between associated objects and indicates that three relationships may exist. For example, A and/or B may indicate the following three cases: Only A exists, both A and B exist, and only B exists, where A or B may be singular or plural. Moreover, in the descriptions of this application, unless otherwise specified, "a plurality of" means two or more than two. "At least one of the following items (pieces)" or a similar expression thereof refers to any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, in embodiments of this application, words such as "first" and " second" are used for distinguishing between same items or similar items that have basically same functions or purposes. A person skilled in the art may understand that the words such as "first" and "second" do not limit a quantity or an execution sequence, and the words such as "first" and " second" do not indicate a definite difference.

In some embodiments, a TB corresponding to the first service may be divided into at least one CB in the following manner. Division herein is not limited to a division action. Instead, there is at least one CB in one TB based on a size of the TB, a size of the CB and/or a quantity of CBs, and another possible setting. It is set that the first service is transmitted between the first node and the second node, the first node serves as a sending party, and the second node serves as a receiving party. The size of the CB and/or the quantity of CBs are/is exchanged between the first node and the second node in advance. Alternatively, the size of the CB, the quantity of CBs, and/or the like may be preconfigured on the first node and the second node. This is not limited. The first node may divide the TB into at least one CB based on at least one of the size of the CB and/or the quantity of CBs. For example, if one TB includes 2400 bits, and a size of each CB is 30 bits, the TB includes 80 CBs. In this case, the first node may divide the TB into 80 CBs, and a size of each CB is 30 bits. After receiving the first service from the first node, the second node serving as the receiving party may obtain or determine, based on the at least one of the size of the CB and/or the quantity of CBs, a TB or a CB corresponding to the first service. The foregoing example is still used. For example, after receiving the first service from the first node, the second node may consider every 30 bits as one CB, and consider every 80 CBs as one TB. Optionally, if the quantity of CBs is 1, in some scenarios, the TB and the CB are equivalent, that is, the TB is directly considered as the CB.

In a possible implementation, the first node and the second node may negotiate the at least one of the size of the CB and/or the quantity of CBs. For example, the first node and the second node may exchange the at least one of the size of the CB and/or the quantity of CBs by using higher layer signaling (for example, radio resource control signaling) or other signaling. Alternatively, the first node may be a master node, the second node may be a slave node, and the first node may send indication information to the second node, where the indication information is used for indicating the at least one of the size of the CB and/or the quantity of CBs. Alternatively, the second node is a master node, the first node is a slave node, and the second node may send, to the first node, the indication information used for indicating the size of the CB and/or the quantity of the CBs. Optionally, the indication information may be included in node capability information, auxiliary information, or the like. For example, the auxiliary information may include at least one of service feature information, attribute information, or the like. The indication information may be a part or all of the attribute information, or the indication information may be a part or all of the service feature information. Further optionally, the indication information may be carried in higher layer signaling, for example, radio resource control signaling. It may be understood that the foregoing is described by using an example in which the master node notifies the slave node of the size of the CB and/or the quantity of the CBs. In some embodiments, a manner in which the slave node notifies the master node may alternatively be used. This is not limited. Even in some embodiments, in the first node and the second node, the master node and the slave node are not distinguished, or both the first node and the second node may be slave nodes. In this case, either of the two nodes may notify the other node. Optionally, in embodiments of this application, the master node may also be referred to as a C node or a control node, and the slave node may also be referred to as a T node, a terminal, or the like. A transmission link from the master node to the slave node may be referred to as a C link or a downlink, and a transmission link from the slave node to the master node may be referred to as a T link or an uplink.

In a possible implementation, in the first node or the second node, specifically, a higher layer, for example, a MAC layer, may obtain the at least one of the size of the CB and/or the quantity of CBs. Then, the higher layer notifies a physical layer, and the physical layer performs processes such as TB division or integration and channel coding. In comparison with a current solution in which a physical layer determines a size of each CB, a quantity of CBs, and/or the like based on a size of a transport block TB and a maximum allowed size of a CB, a feature of a service can be more effectively matched.

It should be noted that, in embodiments of this application, the first service may be transmitted between the first node and the second node through a wireless communication link. The wireless communication link between the first node and the second node may include various types of connection media, for example, a short-distance connection technology including 802.11b/g, Bluetooth (Bluetooth), Zigbee (Zigbee), a radio frequency identification (radio frequency identification, RFID) technology, an ultra wideband (ultra wideband, UWB) technology, or a wireless short-range communication system (for example, an in-vehicle wireless short-range communication system), and for another example, a long-distance connection technology including a radio access technology such as a global system for mobile communication (global system for mobile communication, GSM), a general packet radio service (general packet radio service, GPRS), or a universal mobile telecommunication system (universal mobile telecommunication system, UMTS). Certainly, there is another wireless communication technology that may be used for supporting communication between the first node and the second node.

The following describes a method for performing channel coding on a CB. As shown in FIG. 4, a procedure of a communication method is provided. The procedure includes at least the following steps.

Step 400: A first node performs channel coding on at least one CB. Further, the at least one CB is a CB of a first service.

The at least one CB is obtained by using a first TB, and the first TB is a TB of the first service. Optionally, the first TB is transmitted in one radio frame or in a plurality of consecutive radio frames, and a length of the radio frame is approximately 20.833 microseconds (us). Specifically, the at least one CB is obtained by performing CRC attachment (attachment) on at least one segment (segment) in the first TB. That is, the at least one CB in this application is a CB to which a CRC is attached.

Optionally, no CRC attachment is performed on the first TB, or no CRC is attached to the first TB. Such a design reduces complexity of channel coding. Especially for a service that has a relatively high latency requirement, for example, the first service, a length of transmitted information may be reduced, so that a low latency is further ensured while complexity of channel coding is reduced.

In an optional implementation, that the at least one CB is obtained by using the first TB includes: The at least one CB is obtained by using at least one TB of the first service based on at least one of a size of a CB or a quantity of CBs corresponding to the first service. Optionally, there may be one or more first TBs of the first service.

Specifically, the at least one of the size of the CB or the quantity of CBs corresponding to the first service may be locally obtained by the first node, or indicated by indication information received from another node (for example, a second node), or obtained through pre-agreement or pre-negotiation, or may be predefined in a standard or a protocol. The indication information is received from the another node to obtain the at least one of the size of the CB or the quantity of CBs, so that the CB can be configured more flexibly.

Further, it can be learned from the foregoing description that the size of the CB may be a size of an information bit of a CB, or a sum of a size of an information bit and a size of a cyclic redundancy check CRC. In an implementation, if the size that is of the CB and that is obtained by the second node is the size of the information bit of the CB, the second node needs to obtain the at least one CB by using the first TB based on the size of the CB and the size of the CRC. In another implementation, if the size that is of the CB and that is obtained by the second node is the sum of the size of the information bit and the size of the cyclic redundancy check CRC, the second node obtains the at least one CB by using the first TB based on the obtained size of the CB. Optionally, the size of the CRC attached to the CB is predefined, for example, predefined according to a standard or a protocol. Alternatively, the size of the CRC may be preconfigured, pre-negotiated, or notified by using signaling.

Specifically, the foregoing channel coding process may be: performing channel coding on each of the at least one CB based on a mother code length of the CB; or performing channel coding on the at least one CB based on a mother code length of a CB, where the mother code length of the CB is determined based on at least one of a maximum mother code length, a minimum mother code length, or a minimum mother code rate.

In a possible implementation, the mother code length of the CB may be represented as $N = 2^n$, K is used for representing a length of one CB before channel coding, and E is used for representing a length of one CB after rate matching. In this case, a value of n meets the following condition:

If $E \leq (9/8) * 2^{(\lceil \log_2 E \rceil)}$ and $K/E < 9/16$,

$$n_1 = \lceil \log_2 E \rceil - 1$$ ;

otherwise, $n_1 = \lceil \log_2 E \rceil$ ; and

$$n_2 = \lceil \log_2 (K/R_{min}) \rceil$$ , where $R_{min}$ represents the minimum mother code rate, and a value of $R_{min}$ may

be 1/8; and

$$n = \max \{ \min \{ n_1, n_2, n_{max} \}, n_{min} \}$$ .

$n_{max}$ represents n corresponding to the maximum mother code length. For example, if the maximum mother code length is 128, $128 = 2' = 2^{n_{max}}$, and a value of $n_{max}$ is 7. $n_{min}$ represents n corresponding to the minimum mother code length. For example, if the minimum mother code length is 32, $32 = 2^5 = 2^{n_{min}}$, and a value of $n_{min}$ is 5.

Step 401: The first node sends, to the second node, the at least one CB on which channel coding has been performed, where the at least one CB is the CB of the first service. Alternatively, step 401 may be understood as follows: The first node sends, to the second node, a bit stream corresponding to the at least one CB on which channel coding has been performed. Herein, for ease of description, description of the bit stream is omitted.

It should be noted that the solution of this application focuses on describing channel coding for the CB. Therefore, only "sending the at least one CB on which channel coding has been performed" is described in step 401. However, a person skilled in the art may learn that the first node does not send the at least one CB to the second node after performing only channel coding on the at least one CB. An actual communication process may further include but is not limited to: The first node performs at least one type of processing of rate matching, code block concatenation, data and control multiplexing, or channel interleaving on the at least one CB on which channel coding has been performed; and then sends, to the second node, at least one CB obtained after the at least one type of processing (or a bit stream corresponding to the at least one CB).

Step 402: Correspondingly, the second node performs channel decoding on the at least one CB. Optionally, the foregoing channel decoding process may be as follows: The second node performs channel decoding on each of the at least one CB based on a mother code length of the CB; or the second node may perform channel decoding on the at least one CB based on a mother code length of a CB, where the mother code length of the CB is determined based on at least one of a maximum mother code length, a minimum mother code length, or a minimum mother code rate. For a process of determining the mother code length of the CB based on at least one of the foregoing three, refer to the foregoing description. Refer to the description of step 401. Corresponding to the processing on the first node side, the second node may further perform at least one of channel de-interleaving, data and control demultiplexing, code block de-concatenation, rate de-matching, or the like on the at least one TB/CB. For ease of description, a specific process is not described in detail herein.

In in-vehicle wireless short-range communication, for a first-type data service, that is, a noise reduction service, a length of an information bit of each CB is 16, 24, 32, or the like, and a physical layer resource may be randomly allocated. According to a current mother code selection principle, a maximum mother code length may reach 4096. For the first-type data service, complexity is excessively high. This is not conducive to reducing a latency. To reduce complexity and match the length of the information bit of each CB, the mother code length needs to be limited. For example, the maximum mother code length is limited to 128 or 256.

For the first-type data service, a minimum length of each code block is 24 bits (including an 8-bit CRC). If a maximum code rate of the code block does not exceed 7/8, when a minimum mother code length of the code block is 32, a requirement is met. In addition, because a maximum length of each code block is 40, even if a mother code length 128 is used, a code rate of the code block is basically 1/3. Based on a common resource allocation granularity, the maximum mother code length 128 can meet an application requirement. Therefore, in a possible implementation method, for the first-type data service, the minimum mother code length and the maximum mother code length may be respectively set to 32 and 128. The maximum mother code length of the first-type data service is limited to 128, and the minimum mother code length of the first-type data service is limited to 32. The advantages are as follows.

If a maximum/minimum mother code length of each CB is not limited, a mother code length of each CB may be 32, 64, 128, 256, 512, 1024, 2048, 4096, or the like. Consequently, there are too many mother code types, and device implementation complexity is relatively high. This is not conducive to cost reduction, and also causes performance deterioration. However, in this embodiment of this application, the maximum mother code length of the first-type data service is limited to 128, the minimum mother code length of the first-type data service is limited to 32, and the mother code length of each CB of the first-type data service may have four types such as 32, 64, and 128. In this way, a quantity of mother code types is decreased and device complexity is reduced.

It can be learned from the foregoing that the maximum mother code length of the first-type data service is limited to 128, so that device complexity is reduced while a service requirement is met; and the minimum mother code length of the first-type data service is limited to 32, so that a service requirement that a minimum length of a CB is 24 bits can be met. Certainly, the foregoing description is provided by using an example in which the maximum mother code length is 128. If the maximum mother code length is 256, the maximum mother code length is still less than the maximum mother code length 4096 in the current solution, and advantages are similar.

In a possible implementation method, the solution provided in this embodiment of this application may also be applied to a channel coding process of control information. The control information may be control signaling carried on a C link, control signaling carried on a T link, or the like. For example, in in-vehicle wireless short-range communication, the channel coding scheme provided in this embodiment of this application can be used for both the first-type data service and the control information. In comparison with using different channel coding schemes for the first-type data service and the control information, implementation complexity can be reduced.

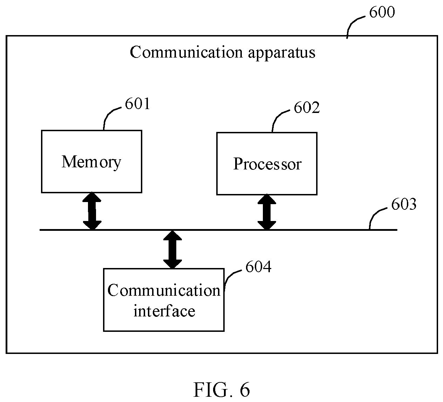

The method provided in embodiments of this application is described above in detail with reference to FIG. 1 to FIG. 4. The apparatus provided in embodiments of this application is described below in detail with reference to FIG. 5 and FIG. 6. It should be understood that descriptions of apparatus embodiments correspond to descriptions of the method embodiments. Therefore, for content that is not described in detail, refer to the descriptions in the foregoing method embodiments.

FIG. 5 is a schematic block diagram of an apparatus 500 according to an embodiment of this application. The apparatus 500 is configured to implement a function of the first node or the second node in the embodiment shown in FIG. 4. For example, the apparatus may be a software unit or a chip system. The chip system may include a chip, or may include a chip and another discrete device. The apparatus includes a communication unit 501, and may further include a processing unit 502. The communication unit 501 may communicate with an external device. The processing unit 502 is configured to perform processing. The communication unit 501 may also be referred to as a communication interface, a transceiver unit, an input/output interface, or the like. The communication unit 501 may include a sending unit, a receiving unit, and/or the like.

In an example, the apparatus 500 may implement the function of the first node in the embodiment shown in FIG. 4. The apparatus 500 may be the first node, or a chip or a circuit disposed in the first node. The communication unit 501 is configured to perform transceiving operations of the first node in the embodiment shown in FIG. 4, and the processing unit 502 is configured to perform processing-related operations of the first node in the embodiment shown in FIG. 4.

For example, the processing unit 502 is configured to perform channel coding on at least one code block; and the communication unit 501 is configured to send, to a second node, the at least one code block on which channel coding has been performed, where the at least one code block is a code block of a first service.

Optionally, the processing unit 502 is further configured to obtain at least one of a size of a code block or a quantity of code blocks corresponding to the first service; and the processing unit 502 is further configured to obtain the at least one code block by using at least one transport block of the first service based on the at least one of the size of the code block or the quantity of code blocks.

Optionally, the size of the code block is a sum of a size of an information bit of the code block and a size of a cyclic redundancy check CRC, or the size of the code block is a size of an information bit of the code block.

Optionally, no CRC is attached to the at least one transport block of the first service.

Optionally, the performing channel coding on at least one code block includes: performing channel coding on each of the at least one code block based on a mother code length of the code block, where the mother code length of the code block is determined based on at least one of a maximum mother code length, a minimum mother code length, or a minimum mother code rate; or performing channel coding on the at least one code block based on a mother code length of a code block, where the mother code length of the code block is determined based on at least one of a maximum mother code length, a minimum mother code length, or a minimum mother code rate.

Optionally, the maximum mother code length is 128 or 256.

Optionally, the minimum mother code length is 32.

Optionally, the minimum mother code rate is 1/8.

Optionally, the first service is a noise reduction data service.

The communication unit 501 is further configured to send indication information to the second node, where the indication information is used for indicating the at least one of the size of the code block or the quantity of code blocks corresponding to the first service; or the communication unit 501 is further configured to receive indication information from the second node, where the indication information is used for indicating the at least one of the size of the code block or the quantity of code blocks corresponding to the first service.

In another example, the apparatus 500 may implement the function of the second node in the embodiment shown in FIG. 4. The apparatus 500 may be the second node, or a chip or a circuit disposed in the second node. The communication unit 501 is configured to perform transceiving operations of the second node in the embodiment shown in FIG. 4, and the processing unit 502 is configured to perform processing-related operations of the second node in the embodiment shown in FIG. 4.

For example, the communication unit 501 is configured to receive a first service from a first node, where the first service includes at least one code block; and the processing unit 502 is configured to perform channel decoding on the at least one code block.

Optionally, the processing unit 502 is further configured to obtain at least one of a size of a code block or a quantity of code blocks corresponding to the first service; and the processing unit 502 is further configured to obtain at least one transport block of the first service based on the at least one of the size of the code block or the quantity of code blocks.

Optionally, the size of the code block is a sum of a size of an information bit of the code block and a size of a cyclic redundancy check CRC, or the size of the code block is a size of an information bit of the code block.

Optionally, no CRC is attached to the at least one transport block of the first service.

Optionally, the performing channel decoding on the at least one code block includes: performing channel decoding on each of the at least one code block based on a mother code length of the code block, where the mother code length of the code block is determined based on at least one of a maximum mother code length, a minimum mother code length, or a minimum mother code rate; or performing channel decoding on the at least one code block based on a mother code length of a code block, where the mother code length of the code block is determined based on at least one of a maximum mother code length, a minimum mother code length, or a minimum mother code rate.

Optionally, the maximum mother code length is 128 or 256.

Optionally, the minimum mother code length is 32.

Optionally, the minimum mother code rate is 1/8.

Optionally, the first service is a noise reduction data service.

Optionally, the communication unit 501 is further configured to receive indication information from the first node, where the indication information is used for indicating the at least one of the size of the code block or the quantity of code blocks corresponding to the first service; or the communication unit 501 is further configured to send indication information to the first node, where the indication information is used for indicating the at least one of the size of the code block or the quantity of code blocks corresponding to the first service.

In embodiments of this application, division into the units is an example, is merely logical function division, and may be other division during actual implementation. In addition, functional units in embodiments of this application may be integrated into one processor, or each of the units may exist alone physically, or two or more units may be integrated into one unit. The integrated unit may be implemented in a form of hardware, or may be implemented in a form of a software functional unit.

It may be understood that in the foregoing embodiment, a function of the communication unit may be implemented by a communication interface, and a function of the processing unit may be implemented by a processor. The communication interface may include a transmitter, a receiver, and/or the like, respectively configured to implement functions of the sending unit and/or the receiving unit. The following provides description by using an example with reference to FIG. 6.

FIG. 6 is a schematic diagram of a structure of a communication apparatus 600 according to an embodiment of this application. The communication apparatus 600 may be a node, or may be a component in a node, for example, a chip or an integrated circuit. The apparatus 600 may include at least one processor 602 and a communication interface 604. Optionally, the apparatus 600 may further include at least one memory 601. Further optionally, a bus 603 may be further included. The memory 601, the processor 602, and the communication interface 604 are connected through the bus 603.

The memory 601 is configured to provide storage space, where the storage space may store data such as an operating system and a computer program. The memory 601 may be one or a combination of a plurality of a random access memory (random access memory, RAM), a read-only memory (read-only memory, ROM), an erasable programmable read-only memory (erasable programmable read-only memory, EPROM), a portable read-only memory (compact disc read-only memory, CD-ROM), or the like.

The processor 602 is a module that performs an arithmetic operation and/or a logical operation, and may be specifically one or a combination of a plurality of processing modules such as a central processing unit (central processing unit, CPU), a graphics processing unit (graphics processing unit, GPU), a microprocessor unit (microprocessor unit, MPU), an application-specific integrated circuit (application-specific integrated circuit, ASIC), a field programmable gate array (field programmable gate array, FPGA), a complex programmable logic device (complex programmable logic device, CPLD), a coprocessor (assisting the central processing unit in completing corresponding processing and application), and a microcontroller unit (microcontroller unit, MCU).

The communication interface 604 may be configured to provide an information input or output for the at least one processor; and/or the communication interface 604 may be configured to receive data sent by an external device and/or send data to the external device, and may be a wired link interface including an Ethernet cable or the like, or may be a wireless link (Wi-Fi, Bluetooth, universal wireless transmission, an in-vehicle short-range communication technology, or the like) interface. Optionally, the communication interface 604 may further include a transmitter (for example, a radio frequency transmitter or an antenna), a receiver, or the like coupled to the interface.

The processor 602 in the apparatus 600 is configured to read the computer program stored in the memory 601, to perform the foregoing communication method, for example, the communication method described in the embodiment shown in FIG. 4.

For example, the communication apparatus 600 may be the first node in the embodiment shown in FIG. 4. The processor 602 in the apparatus 600 is configured to read the computer program stored in the memory 601, to perform the following operations: performing channel coding on at least one code block; and controlling the communication interface 604 to send, to a second node, the at least one code block on which channel coding has been performed, where the at least one code block is a code block of a first service. For specific details, refer to the description in the foregoing method embodiment. Details are not described again.

Alternatively, the communication apparatus 600 may be the second node in the embodiment shown in FIG. 4. The processor 602 in the apparatus 600 is configured to read the computer program stored in the memory 601, to perform the following operations: controlling the communication interface 604 to receive a first service from a first node, where the first service includes at least one code block; and performing channel decoding on the at least one code block. For specific details, refer to the description in the foregoing method embodiment. Details are not described again.

An embodiment of this application further provides a computer-readable storage medium. The computer-readable storage medium stores a computer program. When the computer program is run on one or more processors, the method in the embodiment shown in FIG. 4 is implemented.

An embodiment of this application further provides a chip system. The chip system includes at least one processor and a communication interface. The communication interface is configured to send and/or receive data. The at least one processor is configured to invoke a computer program stored in at least one memory, to implement the method in the embodiment shown in FIG. 4.

Further, the at least one processor may include at least one of a CPU, an MPU, an MCU, or a coprocessor

An embodiment of this application further provides a terminal. The terminal may be a smart cockpit product, a vehicle, or the like. The terminal includes a first node and/or a second node. The first node (for example, one or more of modules such as a camera, a screen, a microphone, a speaker, a radar, an electronic key, a passive entry passive start system controller, and user equipment UE) is the first node in the embodiment shown in FIG. 4, and the second node (for example, a base station or a vehicle cockpit domain controller CDC) is the second node in the embodiment shown in FIG. 4.

Further optionally, the terminal may be an uncrewed aerial vehicle, a robot, a device in a smart home scenario, a device in a smart manufacturing scenario, or the like.

An embodiment of this application further provides a computer program product. When the computer program product runs on one or more processors, the communication method described in the embodiment shown in FIG. 4 may be implemented.

All or a part of the foregoing embodiments may be implemented by using software, hardware, firmware, or any combination thereof. When software is used to implement the embodiments, all or a part of the embodiments may be implemented in a form of a computer instruction product. When computer instructions are loaded and executed on a computer, the procedures or functions according to embodiments of this application are all or partially implemented. The computer may be a general-purpose computer, a dedicated computer, a computer network, or another programmable apparatus. The computer instructions may be stored in a computer-readable storage medium, or may be transmitted by using a computer-readable storage medium. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

Sequence adjustment, combination, or deletion may be performed on the steps in the method embodiment of this application based on an actual requirement.

Combination, division, and deletion may be performed on the modules in the apparatus embodiments of this application based on an actual requirement.

**Claims**

1.  A communication method, wherein the method comprises:

    performing channel coding on at least one code block; and
    sending, to a second node, the at least one code block on which channel coding has been performed, wherein the at least one code block is a code block of a first service.

2.  The method according to claim 1, wherein the method further comprises:

    obtaining at least one of a size of a code block or a quantity of code blocks corresponding to the first service; and
    obtaining the at least one code block by using at least one transport block of the first service based on the at least one of the size of the code block or the quantity of code blocks.

3.  The method according to claim 2, wherein the size of the code block is a sum of a size of an information bit of the code block and a size of a cyclic redundancy check CRC, or the size of the code block is a size of an information bit of the code block.

4.  The method according to any one of claims 1 to 3, wherein no CRC is attached to the at least one transport block of the first service.

5.  The method according to any one of claims 1 to 4, wherein the performing channel coding on at least one code block comprises:

    performing channel coding on each of the at least one code block based on a mother code length of the code block, wherein the mother code length of the code block is determined based on at least one of a maximum mother code length, a minimum mother code length, or a minimum mother code rate; or
    performing channel coding on the at least one code block based on a mother code length of a code block, wherein the mother code length of the code block is determined based on at least one of a maximum mother code length, a minimum mother code length, or a minimum mother code rate.

6.  The method according to claim 5, wherein the maximum mother code length is 128 or 256.

7.  The method according to claim 5 or 6, wherein the minimum mother code length is 32.

8.  The method according to any one of claims 5 to 7, wherein the minimum mother code rate is 1/8.

9.  The method according to any one of claims 1 to 8, wherein the first service is a noise reduction data service.

10. The method according to any one of claims 1 to 9, wherein the method further comprises:

    sending indication information to the second node, wherein the indication information is used for indicating the at least one of the size of the code block or the quantity of code blocks corresponding to the first service; or
    receiving indication information from the second node, wherein the indication information is used for indicating the at least one of the size of the code block or the quantity of code blocks corresponding to the first service.

11. A communication method, comprising:

    receiving a first service from a first node, wherein the first service comprises at least one code block; and
    performing channel decoding on the at least one code block.

12. The method according to claim 11, wherein the method further comprises:

    obtaining at least one of a size of a code block or a quantity of code blocks corresponding to the first service; and
    obtaining at least one transport block of the first service based on the at least one of the size of the code block or the quantity of code blocks.

13. The method according to claim 12, wherein the size of the code block is a sum of a size of an information bit of the code block and a size of a cyclic redundancy check CRC, or the size of the code block is a size of an information bit of the code block.

14. The method according to any one of claims 11 to 13, wherein no CRC is attached to the at least one transport block of the first service.

15. The method according to any one of claims 11 to 14, wherein the performing channel decoding on the at least one code block comprises:

performing channel decoding on each of the at least one code block based on a mother code length of the code block, wherein the mother code length of the code block is determined based on at least one of a maximum mother code length, a minimum mother code length, or a minimum mother code rate; or performing channel decoding on the at least one code block based on a mother code length of a code block, wherein the mother code length of the code block is determined based on at least one of a maximum mother code length, a minimum mother code length, or a minimum mother code rate.

16. The method according to claim 15, wherein the maximum mother code length is 128 or 256.

17. The method according to claim 15 or 16, wherein the minimum mother code length is 32.

18. The method according to any one of claims 15 to 17, wherein the minimum mother code rate is 1/8.

19. The method according to any one of claims 11 to 18, wherein the first service is a noise reduction data service.

20. The method according to any one of claims 11 to 19, wherein the method further comprises:

receiving indication information from the first node, wherein the indication information is used for indicating the at least one of the size of the code block or the quantity of code blocks corresponding to the first service; or sending indication information to the first node, wherein the indication information is used for indicating the at least one of the size of the code block or the quantity of code blocks corresponding to the first service.

21. A communication apparatus, comprising:

a processing unit, configured to perform channel coding on at least one code block; and a communication unit, configured to send, to a second node, the at least one code block on which channel coding has been performed, wherein the at least one code block is a code block of a first service.

22. The apparatus according to claim 21, wherein

the processing unit is further configured to obtain at least one of a size of a code block or a quantity of code blocks corresponding to the first service; and the processing unit is further configured to obtain the at least one code block by using at least one transport block of the first service based on the at least one of the size of the code block or the quantity of code blocks.

23. The apparatus according to claim 22, wherein the size of the code block is a sum of a size of an information bit of the code block and a size of a cyclic redundancy check CRC, or the size of the code block is a size of an information bit of the code block.

24. The apparatus according to any one of claims 21 to 23, wherein no CRC is attached to the at least one transport block of the first service.

25. The apparatus according to any one of claims 21 to 24, wherein the performing channel coding on at least one code block comprises:

performing channel coding on each of the at least one code block based on a mother code length of the code block, wherein the mother code length of the code block is determined based on at least one of a maximum mother code length, a minimum mother code length, or a minimum mother code rate; or

performing channel coding on the at least one code block based on a mother code length of a code block, wherein the mother code length of the code block is determined based on at least one of a maximum mother code length, a minimum mother code length, or a minimum mother code rate.

26. The apparatus according to claim 25, wherein the maximum mother code length is 128 or 256.

27. The apparatus according to claim 25 or 26, wherein the minimum mother code length is 32.

28. The apparatus according to any one of claims 25 to 27, wherein the minimum mother code rate is 1/8.

29. The apparatus according to any one of claims 21 to 28, wherein the first service is a noise reduction data service.

30. The apparatus according to any one of claims 21 to 29, wherein

the communication unit is further configured to send indication information to the second node, wherein the indication information is used for indicating the at least one of the size of the code block or the quantity of code blocks corresponding to the first service; or
the communication unit is further configured to receive indication information from the second node, wherein the indication information is used for indicating the at least one of the size of the code block or the quantity of code blocks corresponding to the first service.

31. A communication apparatus, comprising:

a communication unit, configured to receive a first service from a first node, wherein the first service comprises at least one code block; and
a processing unit, configured to perform channel decoding on the at least one code block.

32. The apparatus according to claim 31, wherein

the processing unit is further configured to obtain at least one of a size of a code block or a quantity of code blocks corresponding to the first service; and
the processing unit is further configured to obtain at least one transport block of the first service based on the at least one of the size of the code block or the quantity of code blocks.

33. The apparatus according to claim 32, wherein the size of the code block is a sum of a size of an information bit of the code block and a size of a cyclic redundancy check CRC, or the size of the code block is a size of an information bit of the code block.

34. The apparatus according to any one of claims 31 to 33, wherein no CRC is attached to the at least one transport block of the first service.

35. The apparatus according to any one of claims 31 to 34, wherein the performing channel decoding on the at least one code block comprises:

performing channel decoding on each of the at least one code block based on a mother code length of the code block, wherein the mother code length of the code block is determined based on at least one of a maximum mother code length, a minimum mother code length, or a minimum mother code rate; or
performing channel decoding on the at least one code block based on a mother code length of a code block, wherein the mother code length of the code block is determined based on at least one of a maximum mother code length, a minimum mother code length, or a minimum mother code rate.

36. The apparatus according to claim 35, wherein the maximum mother code length is 128 or 256.

37. The apparatus according to claim 35 or 36, wherein the minimum mother code length is 32.

38. The apparatus according to any one of claims 35 to 37, wherein the minimum mother code rate is 1/8.

39. The apparatus according to any one of claims 31 to 38, wherein the first service is a noise reduction data service.

**40.** The apparatus according to any one of claims 31 to 39, wherein

the communication unit is further configured to receive indication information from the first node, wherein the indication information is used for indicating the at least one of the size of the code block or the quantity of code blocks corresponding to the first service; or
the communication unit is further configured to send indication information to the first node, wherein the indication information is used for indicating the at least one of the size of the code block or the quantity of code blocks corresponding to the first service.

**41.** A chip system, wherein the chip system comprises at least one processor and a communication interface, and the at least one processor is configured to invoke a computer program stored in at least one memory, so that an apparatus in which the chip system is located implements the method according to any one of claims 1 to 10.

**42.** A chip system, wherein the chip system comprises at least one processor and a communication interface, and the at least one processor is configured to invoke a computer program stored in at least one memory, so that an apparatus in which the chip system is located implements the method according to any one of claims 11 to 20.

**43.** A computer-readable storage medium, wherein the computer-readable storage medium stores a computer program, and when the computer program is run on one or more processors, the method according to any one of claims 1 to 10 is performed.

**44.** A computer-readable storage medium, wherein the computer-readable storage medium stores a computer program, and when the computer program is run on one or more processors, the method according to any one of claims 11 to 20 is performed.

**45.** A communication system, comprising:

a first node, wherein the first node comprises the information transmission apparatus according to any one of claims 21 to 30; and
a second node, wherein the second node comprises the information transmission apparatus according to any one of claims 31 to 40.

FIG. 1

FIG. 2

FIG. 3

| First node | | Second node |
|---|---|---|

**400: The first node performs channel coding on at least one CB**

401: Send the at least one CB on which channel coding has been performed, where the at least one CB is a CB of a first service →

**402: The second node performs channel decoding on the at least one CB**

FIG. 4

500

Communication unit ⟋ 501

Processing unit ⟋ 502

FIG. 5

600

Communication apparatus

601

Memory

602

Processor

603

604

Communication
interface

FIG. 6

## INTERNATIONAL SEARCH REPORT

| International application No. |
| --- |
| **PCT/CN2020/113853** |

| A. | CLASSIFICATION OF SUBJECT MATTER |
| --- | --- |

H04L 1/00(2006.01)i;  H03M 13/09(2006.01)i

According to International Patent Classification (IPC) or to both national classification and IPC

| B. | FIELDS SEARCHED |
| --- | --- |

Minimum documentation searched (classification system followed by classification symbols)

H04L; H03M; H04W

Documentation searched other than minimum documentation to the extent that such documents are included in the fields searched

Electronic data base consulted during the international search (name of data base and, where practicable, search terms used)

CNKI; CNPAT; WPI; EPODOC; 3GPP: 编码块, 传输块, 信道编码, 母码, 长度, 数量, 大小, 车联网, 车载通信, 无线, 校验, CRC, CB, TB, channel encod+, length, number, wireless, verify

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 111405503 A (LONGBO COMMUNICATION TECHNICAL CO., LTD.) 10 July 2020 (2020-07-10)<br>  description paragraphs [0006]-[0048], [0068], [0156]-[0164], [1004] | 1-45 |
| A | CN 107800510 A (HUAWEI TECHNOLOGIES CO., LTD.) 13 March 2018 (2018-03-13)<br>  entire document | 1-45 |
| A | CN 103326756 A (ZTE CORPORATION) 25 September 2013 (2013-09-25)<br>  entire document | 1-45 |
| A | CN 109391356 A (HUAWEI TECHNOLOGIES CO., LTD.) 26 February 2019 (2019-02-26)<br>  entire document | 1-45 |
| A | US 2019014554 A1 (SHANGHAI LANGBO COMMUNICATION TECHNOLOGY COMPANY LIMITED) 10 January 2019 (2019-01-10)<br>  entire document | 1-45 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **26 May 2021** | **03 June 2021** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/113853**

| Patent document cited in search report | | | Publication date (day/month/year) | Patent family member(s) | | | Publication date (day/month/year) |
|---|---|---|---|---|---|---|---|
| CN | 111405503 | A | 10 July 2020 | WO | 2020140827 | A1 | 09 July 2020 |
| CN | 107800510 | A | 13 March 2018 | EP | 3496311 | A1 | 12 June 2019 |
| | | | | WO | 2018040822 | A1 | 08 March 2018 |
| | | | | US | 2019199474 | A1 | 27 June 2019 |
| CN | 103326756 | A | 25 September 2013 | WO | 2013139259 | A1 | 26 September 2013 |
| CN | 109391356 | A | 26 February 2019 | | None | | |
| US | 2019014554 | A1 | 10 January 2019 | CN | 109217981 | A | 15 January 2019 |

Form PCT/ISA/210 (patent family annex) (January 2015)